# EUROPEAN PATENT APPLICATION

(11) **EP 2 025 773 A1**
(43) Date of publication of application: **18.02.2009**
(21) Application number: 07014181.7
(22) Date of filing: 19.07.2007
(51) Int. Cl.: C23C 14/24, C23C 14/26

(54) **Vacuum evaporation apparatus for solid materials**

(71) Applicant: Applied Materials, Inc., Santa Clara, CA 95054 (US)
(72) Inventor: Schäfer, Micheal, 63674 Altenstadt (DE); Meyer, Bernd, 63739 Aschaffenburg (DE)
(74) Representative: Schickedanz, Willi

(57) **Abstract**

The invention relates to an apparatus for evaporating solid materials, for instance, selenium for coating a substrate. The solid material is brought into a first crucible via a feeding source. In this crucible the material melts at a temperature which is preferably slightly higher than its melting point. The molten material flows via a transporting device, for instance, a pipe into a second crucible, where the material evaporates at a temperature higher than its boiling point and is transported to a substrate. In order to stop the evaporation within a very short time preferably within only one to two minutes, a cooling device for cooling the material beyond its melting point is arranged at the transporting device. With this cooling device the material in the transporting device can be cooled down beyond its melting point in a very short time.

## Description

The invention relates to a vacuum evaporation apparatus for solid materials as defined in claim 1.

An important goal in modern research in energy is to find methods to convert sunlight into current, having only low costs. Thin film solar cells promise to have lower costs compared with common solar cells.

These thin films can, for instance, be produced by a sputtering process or by evaporation of solid materials onto a substrate. A continuous vacuum evaporation device for metal has been described, where a substrate to be coated moves within a vacuum chamber (US 4,880,960). A deposition material in particle form is stored in a reservoir closed on its lowermost part by a plate. A cable links the plate to a valve which closes the supply opening of a crucible heated to a temperature for evaporation of the deposition material. A control device using at least one electromagnet allows the plate to pivot and thus to open the valve. A quantity of powder falls into the crucible, then the plate and the valve are returned to closed position. A screen with a mesh having dimensions smaller than those of the deposition material particles in the crucible allows passage of the vapor only on subsequent deposition onto the substrate.

Furthermore, there is described an apparatus for coating a substrate, wherein the apparatus comprises an evaporation source and a system for distributing the evaporated material onto the substrate (DE 102 24 908 A1). The system for distributing further comprises a line source, wherein the line source and the substrate can be moved relatively to each other.

A method for depositing semiconductor layers on a substrate for evaporation in vacuum and by dosed supply of a base product in N evaporators has also been described (FR 2 456 144). The supply of the product is periodically. Each of the N evaporators is, one after another, heated up to a temperature lower than the boiling temperature of the base product and is loaded with a dose which is necessary for the continuous coating of the active portion of the evaporator and which is sufficient for a complete vaporisation during time T until the next loading.

One problem, however, which exists, when a product is evaporated, is that the evaporation can hardly be stopped within a few seconds. This is because the material has to cool off and this needs some time.

Therefore, it is an object of the present invention to solve the problem mentioned above.

The problem is solved according to the features of claim 1.

The invention therefore relates to an apparatus for evaporating solid materials, for instance, selenium for coating a substrate. The solid material is brought into a first crucible via a feeding source. In this crucible the material melts at a temperature which is preferably slightly higher than its melting point. The molten material flows via a transporting device, for instance, a pipe into a second crucible, where the material evaporates at a temperature higher than its boiling point and is transported to a substrate. In order to stop the evaporation within a very short time preferably within one to two minutes, a cooling device for cooling the material beyond its melting point is arranged at the transporting device. With this cooling device the material in the transporting device can be cooled down beyond its melting point in a very short time.

The invention is shown in the figures and explained by the following description.
Fig. 1 shows a perspective general view of a vacuum evaporation apparatus for solid materials with a substrate to be coated.
Fig. 2 shows a view in direction of A of the apparatus according to Fig. 1 without the substrate.
Fig. 3 shows a cut B-B through the apparatus according to Fig. 1.
Fig. 4 shows a part of another embodiment of the apparatus according to Fig. 1.

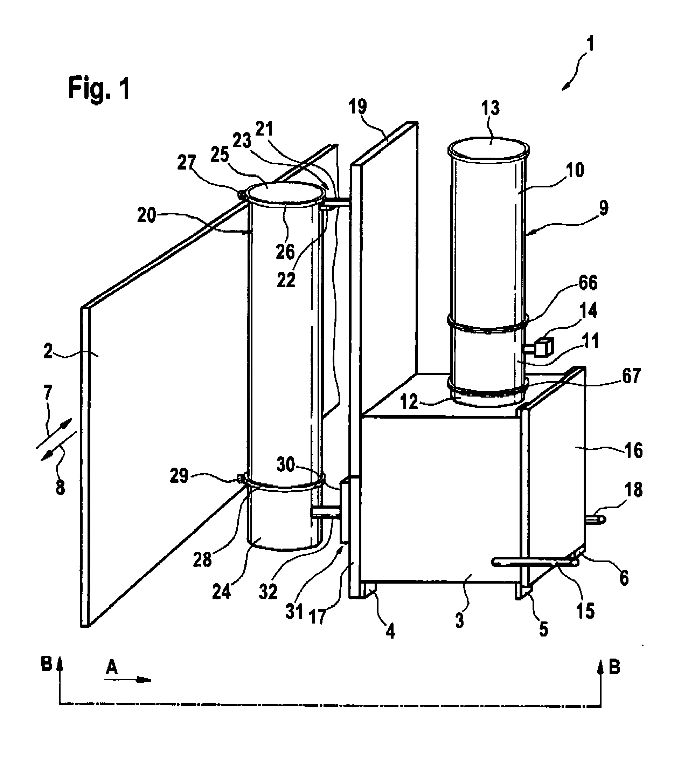

Fig. 1 shows a perspective general view of a vacuum evaporation apparatus 1 for solid materials and a substrate 2. This substrate 2, e.g. a glass plate, is moved relatively to the apparatus 1 in the direction 7 or 8, respectively. The apparatus 1 comprises a housing 3 having feet for a safe standing. In Fig. 1 only the feet 4, 5, 6 can be seen.

On top of the housing 3 a charging device 9 is arranged which has an upper part 10, a middle part 11 and a lower part 12. The middle part 11 is vacuum sealed and provides a charging valve 14. On top of the upper part 10 a removable lid 13 is arranged. This lid 13 can be removed if the upper part 10 has to be provided with solid material, for instance selenium.

However, before the upper part 10 is filled with said solid material, the valve 14 has to be closed. Then the upper part 10 is flooded with a gas, e.g. air or nitrogen, via a pipe which is not shown in Fig. 1. After the upper part 10 has been flooded, the lid 13 is removed and the upper part 10 is provided with the solid material.

Afterwards the lid 13 is replaced and fastened and the upper part 10 is evacuated by a pump not shown in Fig. 1. The upper part 10 can now serve as a reservoir for the solid material.

With the charging valve 14 the quantity of solid material coming from the upper part 10 can be regulated, so that only a defined quantity of solid material passes the lower part 12, before it reaches the interior of the housing 3.

The housing 3 is connected to a pump system via a tube or pipe 15, so that a vacuum can be created in the housing 3. The pump system is not shown in Fig. 1. The apparatus 1 comprises furthermore a first and a second mounting flange 16, 17. On the opposite side of the wall of the housing where the pipe 15 is arranged, another pipe 18 can be seen. This pipe serves for the transport of a cooling media, e.g. water, thermal oil, gas etc.

Onto the mounting flange 17 a third mounting flange 19 is arranged which holds an evaporation pipe 20 via a holding device 21 for holding the evaporation pipe 20. The evaporation pipe 20 itself has a holding device 22 by its own, which is fixed to the holding device 21 of the mounting flange 19. These two holding devices form a holder 23. Although only one holder 23 is shown in Fig. 1, the evaporation pipe 20 can be fixed to the mounting flange 13 by more than one holder 23. However, due to the weight of the evaporation pipe 20, the holder 23 can be omitted.

This evaporation pipe 20 is arranged on a device 24 in which a crucible for evaporating the material is arranged, which cannot be seen in Fig. 1. The evaporation pipe 20 furthermore has a lid 25 which is connected to the evaporation pipe 20 via a ring 26, which is fastened by a fastener 27, e.g. a screw.

As illustrated in Fig. 1, the evaporation pipe 20 is fixed to the device 24 by a ring 28 which also comprises a fastener 29. The evaporation pipe 20 is arranged to the device 24 in such a way that the vapor in the pipe 20 can only leave it by a distribution system of the evaporation pipe 20 which cannot be seen in Fig. 1.

The device 24 is connected to a protrusion 30 of a device 31 for holding a crucible which is arranged inside the housing 3 via a pipe 32.

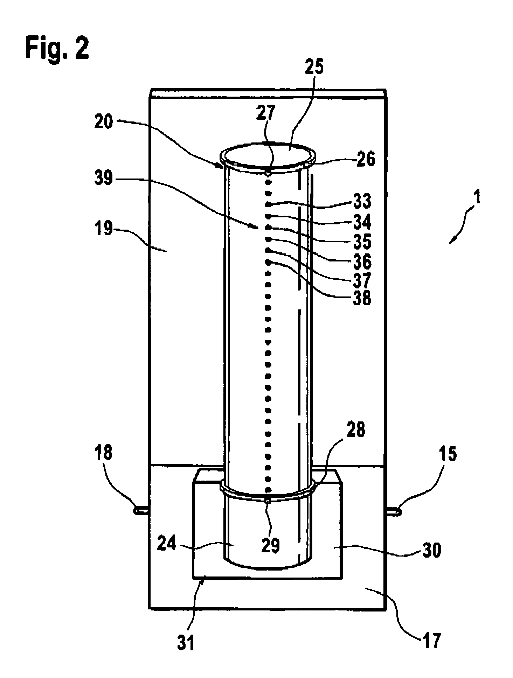

Fig. 2 shows a view in direction of A of the apparatus 1 according to Fig. 1 without the substrate 2. The evaporation pipe 20 being arranged to the mounting flange 19 is connected to the device 24 and fastened to it by the ring 28 and the fastener 29. The evaporation pipe 20 comprises holes 33 to 38 forming a linear distribution system 39, through which the vapor can leave the evaporation pipe 20 and can move towards the substrate. Then the vapor condenses on said substrate to form a film.

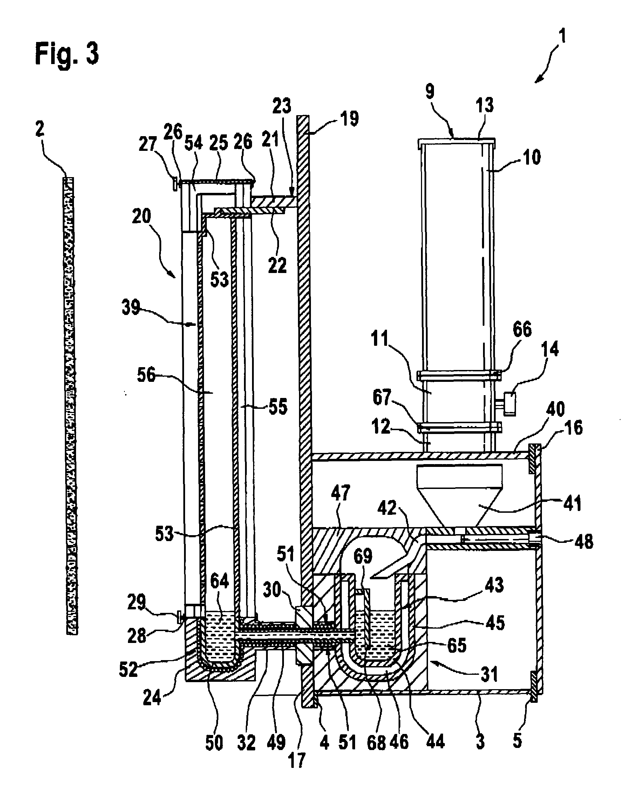

A cut B-B through the apparatus 1 according to Fig. 1 is shown in Fig. 3. There the charging device 9 is mounted on a wall 40 of the housing 3. The upper part 10 serves as a storage room for a solid material, for instance selenium. Below the charging device 9 a storage container 41 is arranged in the housing 3 having a pipe 42 through which the material coming from the charging device 9 can get into a melting crucible 43.

In Fig 3 the storage container 41 has the body structure of a funnel. Furthermore, a pipe 42 and a feeder 48 are arranged in the interior of the housing 3. This feeder 48, for instance a screw conveyer, acts as a device for supplying the pipe 42 with solid material coming from the storage container 41.

The melting crucible 43 is arranged within the device 31 for holding the crucible 43. The crucible 43 can be heated by thermal oil which is kept between two walls 44, 45 in an intermediate room 46. Instead of heating the crucible 43 by thermal oil, it can also be heated by a resistance heater or an induction coil. On top of the crucible 43 a hood 47 is provided. But when the cooling process is started, this intermediate room 46 acts as quick shut down device for cooling, as it serves as a pathway for a cooling medium, for instance water.

Fig. 3 shows furthermore the pipe 32 with an inner pipe 49 in that preferably a resistance heater is arranged. The resistance heater is not shown in Fig. 3, however. This pipe 32 connects the crucible 43 with a crucible 50. This crucible 50 contains molten material 64. In this crucible 50 a heater is arranged, preferably a resistance heater. The inner pipe 49, the pipe 32 as well as the crucibles 50 and 43 can consist of an appropriate metal, ceramics or graphite. The inner pipe 49 is surrounded by a quick shut down device 51 in form of pipes for cooling the molten material in the pipe 49. However, when the heating process takes place, these quick shut down devices act as a pathway for a heating medium, e.g. thermal oil. The shut down device 51 for cooling the molten material in the pipe 49 is arranged on both sides of the protrusion 30.

Another shut down device 52 for cooling is arranged also in form of pipes around the outer parts of the crucible 50. On top of the device 24 holding the crucible 50 the evaporation pipe 20 is arranged.

This evaporation pipe 20 comprises a first inner pipe 53 having the distribution system 39, showing to the side where the substrate 2 passes the apparatus 1. The inner pipe 53 is surrounded by at least one half pipe. In Fig. 3 the inner pipe 53 is surrounded by two half pipes 54, 55. Such an arrangement is shown for instance in Fig. 7 of DE 102 24 908 A1. The inner pipe 53 typically has a high temperature heating device, for example a resistance heater, so that the vapor in the interior 56 of the inner pipe 53 cannot condense.

In Fig. 3 there is shown a dividing wall 68 which is connected to the wall 44 of the crucible 43 via a bar 69. This dividing wall 68 prevents material falling into the liquid material 65 inside the crucible 43 to have an effect on the uncontrolled cooling of the liquid material in the region of the inner pipe 49. The bar 69 and the dividing wall 68 can consist of the same material as the crucible 43, for instance an appropriate metal, graphite or ceramics.

To control the temperature in the apparatus 1, temperature measuring devices can be applied, so that the temperature of the material in the crucibles 43, 50, the pipe 49 and the interior of the pipe 20 can be controlled. The temperature can therefore be adapted to the temperature needed at every stage of the process.

When a coating process is started, the upper part 10 of the charging device 9 is filled with the material used for coating the substrate 2. If the material is selenium, it preferably has the form of granules.

By opening the charging valve 14, the material gets into the storage container 41 without breaking the vacuum. The charging valve 14 will be closed and the material will be transported by the feeder 48 to the pipe 42, to then eventually fall into the crucible 43. In this crucible 43 the material is molten, the crucible 43 having a temperature which is higher than the melting point of the solid material. In the case of selenium the temperature only has to be slightly higher than its melting point of 221 °C.

The quantity of material falling into the crucible 43 can be controlled by the feeder 48, which can be run automatically, so that a variation of the filling amplitude in the crucibles 43, 50 is kept at a minimum. In the housing 3 as well as in the charging device 9 having the lid 13 on top of it, there is a stable vacuum throughout the whole process.

When the heating process is started thermal oil runs through the shut down devices 46, 51 and 52. The thermal oil thus acts as a heating medium. The material in the crucibles 43, 50 and in the pipe 49 hence is heated by that thermal oil.

Once the material got into the crucible 43 it is molten, so that it can pass the pipe 49 and can get into the crucible 50. In this crucible 50 the temperature is much higher in order to convert the liquid material 64 into its gaseous form, i.e. vapor. This vapor rises into the interior 56 of the evaporation pipe 20 and leaves said pipe 20 via the linear distribution system 39. The vapor then moves in the direction of the substrate 2 in order to generate a layer of that material as the substrate 2 passes the apparatus 1. The heater arranged at the inner pipe 53 hinders the vapor to condense at the surface of the inner pipe 53 or in the holes of the distribution system 39.

When the process is stopped the heaters are shut off and the quick shut down devices 51, 52 for cooling are switched on, so that the cooling media, e.g. water, thermal oil, gas, runs through these shut down devices 46, 51, 52 for cooling in order to cool the material down. For a quick cooling of the molten material 64 in the crucible 50, it is important that the crucible 50 does not comprise too much molten material 64. Thus the volume of the crucible 50 is kept quite small compared to the volume of the crucible 43.

It is important to cool the material in the crucibles 43, 50 down to a temperature which lays beyond the melting point. After the material is cooled down, the cooling media is removed from the shut down devices 51, 52 so that the shut down devices 51, 52 can be filled with air again, having a heat capacity which is much lower compared to that of the cooling media.

Cleaning the apparatus is also effortless, because the evaporation pipe 20 can be easily removed by removing the flange 19. After this, the flanges 16, 17 can be removed so that the housing 3 is open to two sides.

Therefore, maintenance of the apparatus 1 is also easy because all devices comprise clutches for quick coupling. Therefore, the device 9 can also be exchanged easily. After having cleaned the apparatus 1 a new process can be started using a new and different material for the coating process.

The charging device 9 can comprise a star feeder with for instance four segments. One of those segments is arranged just above the valve 14, the segment comprising no material.

The charging procedure is started by closing the valve 14 and venting the upper part 10. The lid 13 is then removed from the device 9 and the upper part 10 is charged with the solid material. Thereafter the lid 13 is replaced and the upper part 10 is evacuated by a pump not shown in Fig. 3. After the pressure has been compensated between the upper part 10 of the device 9 and the housing 3 again, the valve 14 can be opened.

By turning the star feeder the material falls through the opening of the valve 14 so that it can get into the crucible 43 via the storage container 41. Afterwards the valve 14 is closed again.

The charging device 9 can also comprise a cup charger having at least one cup. This at least one cup can be canted like a crucible.

After the device 9 is closed by the lid 13, the valve 14 is closed and the upper part 10 is vented. The lid 13 is removed again and the at least one cup is filled with a material. The lid is put on top of the device 9 again and the valve 14 is opened after that the device 9 has been evacuated. Then the at least one cup is canted and the material falls through the opening of the valve 14 into the storage container 41 of the housing 3. From there it runs through the pipe 42 to finally reach the crucible 43.

The device 9 can furthermore comprise a container charger having a rotary hoisting-gear and a hoisting-gear with a charger basket.

When the charging process is started, the valve 14 is closed and the device 9 is vented. The device 9 is then lifted and pivoted to a side. The charging basket is lowered, so that the basket can be changed by a basket filled with material. The basket is then pulled into the device 9 by the hoisting-gear. The device 9 is pivoted over the valve 14 and then put upon the valve 14. The device is then evacuated and the valve opened, so that the material can get into the crucible 43.

In this embodiment the material can be selenium having the form of granules.

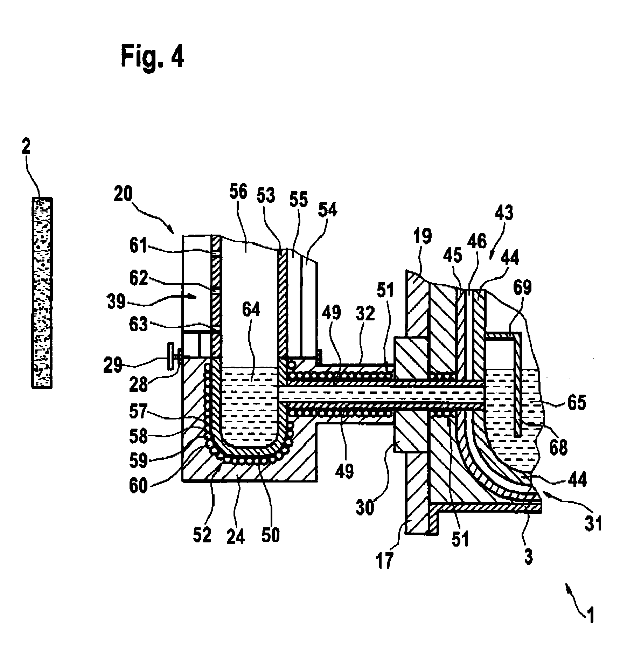

Fig. 4 shows a part of the embodiment of the apparatus 1 according to Fig. 3 drawn to a larger scale. It shows the crucible 50 surrounded by pipes 57, 58, 59, 60 forming the shut down device 52 for cooling arranged in the device 24. On top of the device 24 with the crucible 50 the evaporation pipe 20 is arranged. This pipe 20 has the linear distribution system 39 having openings 61, 62, 63 through which the vapor can leave the evaporation pipe 20. The crucible 50 is connected to the crucible 43 via the inner pipe 49 surrounded by the outer pipe 32. Again, as can be seen in Fig. 4, the pipe 49 is surrounded by the shut down cooling device 51. The crucible 43 which is separated from the crucible 50 by the pipe 49 is formed out of the same material as the pipe 49 and the crucible 50. However, the pipe 49 and the crucibles 50, 43 can be formed out of different materials. The pipe 49 and the crucibles 50, 43 preferably consist of graphite, ceramics or an appropriate metal.

As shown in Fig. 3 there can be seen the dividing wall 68 connected to the crucible 43 by the bar 69. The dividing wall 68 and the bar 69 can consist of the same material as the crucible 43.

Again the liquid material 70, 65, for example selenium, in the two crucibles 50, 43 has approximately the same altitude due to the circumstance that the quantity of the solid material can be controlled automatically via a computer by the valve 14, not shown in Fig. 4, and the feeder 48, not shown in Fig. 4 either. However, the volume of the crucible 50 is much smaller compared to that of the crucible 43.

Instead of the quick shut down devices 46, 51, 52 it is possible to arrange a screen above the crucible 50 to prevent the vapor from leaving the evaporation pipe 20. However, especially in the case when selenium is used as a material, it is hard to prevent selenium from passing the screen because of its high vapor pressure. Such an arrangement would have to be very complex in its construction. Therefore, the shut down devices 46, 51, 52 are preferred.

## Claims

1. Vacuum evaporation apparatus (1) for solid materials comprising a crucible (50) for evaporating at least one material and comprising a distribution system (39) for distributing the at least one evaporated material onto a substrate (2), **characterized in that** the apparatus (1) comprises at least one means (46, 52, 51) for cooling the at least one material beyond its melting point.

2. Vacuum evaporation apparatus (1) according to claim 1, **characterized in that** the apparatus (1) comprises a first crucible (43) for melting the at least one material and a second crucible (50) for evaporating the at least one material.

3. Vacuum evaporation apparatus (1) according to claim 2, **characterized in that** the first crucible (43) is connected to the second crucible (50) via a transporting device (49).

4. Vacuum evaporation apparatus (1) according to claims 1 and 2, **characterized in that** the first crucible (43) is arranged to the at least one means (46) for cooling the at least one material.

5. Vacuum evaporation apparatus (1) according to claims 1 and 2, **characterized in that** the second crucible (50) is arranged to the at least one means (52) for cooling the at least one material.

6. Vacuum evaporation apparatus (1) according to claims 1 to 3, **characterized in that** the transporting device (49) is arranged to the at least one means (51) for cooling the at least one material.

7. Vacuum evaporation apparatus (1) according to claim 1, **characterized in that** a charging device (9) is arranged to the apparatus (1) in the way that the crucible (43) can be provided with the at least one solid material.

8. Vacuum evaporation apparatus (1) according to claim 7, **characterized in that** a transporting system (41, 42) is arranged between the crucible (43) and the charging device (9).

9. Vacuum evaporation apparatus (1) according to claim 8, **characterized in that** the transporting system (41, 42) comprises a feeder (48).

10. Vacuum evaporation apparatus (1) according to claim 7, **characterized in that** the charging device (9) comprises a charging valve (14).

11. Vacuum evaporation apparatus (1) according to claim 2, **characterized in that** the crucible (50) comprises a heater.

12. Vacuum evaporation apparatus (1) according to claim 2, **characterized in that** the crucible (43) comprises a heater.

13. Vacuum evaporation apparatus (1) according to claim 3, **characterized in that** the transporting device (49) comprises a heater.

14. Vacuum evaporation apparatus (1) according to claim 1, **characterized in that** the means (51, 52) for cooling the at least one material comprises at least one pipe (57-60).

15. Vacuum evaporation apparatus (1) according to claim 14, **characterized in that** the means (51, 52) for cooling the at least one material is a pipe system.

16. Vacuum evaporation apparatus (1) according to claims 9 and 10, **characterized in that** the feeder (48) and the valve (14) build a controlling system for keeping the variation of the filling amplitude in the crucibles (43, 50) at a minimum.

17. Vacuum evaporation apparatus (1) according to claims 11,12 and 13, **characterized in that** the heater is a resistance heater.

18. Vacuum evaporation apparatus (1) according to claim 12, **characterized in that** the heater is an inductor.

19. Vacuum evaporation apparatus (1) according to claim 12, **characterized in that** the crucible (43) is heated by thermal oil.

20. Vacuum evaporation apparatus (1) according to claim 1, **characterized in that** the at least one material is selenium.

21. Vacuum evaporation apparatus (1) according to claim 1, **characterized in that** the at least one means (46, 52, 51) for cooling the at least one material also serves as a means for heating the at least one material.

22. Vacuum evaporation apparatus (1) according to claim 1, **characterized in that** the means (46, 52, 51) for cooling are quick shut down devices.

## Amended claims

### Amended claims in accordance with Rule 137(2) EPC.

**1.** Vacuum evaporation apparatus (1) for solid materials comprising a crucible (50) for evaporating at least one material and comprising a distribution system (39) for distributing the at least one evaporated material onto a substrate (2), the apparatus (1) comprising at least one means (46, 52, 51) for cooling the at least one material beyond its melting point,
**characterized in that** a charging device (9) is arranged in the apparatus (1) so
that the crucible (43) can be provided with the at least one solid material.

**2.** Vacuum evaporation apparatus (1) according to claim 1, **characterized in that** the apparatus (1) comprises a first crucible (43) for melting the at least one
material and a second crucible (50) for evaporating the at least one material.

**3.** Vacuum evaporation apparatus (1) according to claim 2, **characterized in that** the first crucible (43) is connected to the second crucible (50) via a transporting
device (49).

**4.** Vacuum evaporation apparatus (1) according to claims 1 and 2, **characterized**
**in that** the first crucible (43) is arranged to the at least one means (46) for cooling the at least one material.

**5.** Vacuum evaporation apparatus (1) according to claims 1 and 2, **characterized**
**in that** the second crucible (50) is arranged to the at least one means (52) for
cooling the at least one material.

**6.** Vacuum evaporation apparatus (1) according to claims 1 to 3, **characterized in that** the transporting device (49) is arranged to the at least one means (51) for
cooling the at least one material.

**7.** Vacuum evaporation apparatus (1) according to claim 1, **characterized in that** a transporting system (41, 42) is arranged between the crucible (43) and the
charging device (9).

**8.** Vacuum evaporation apparatus (1) according to claim 7, **characterized in that** the transporting system (41, 42) comprises a feeder (48).

**9.** Vacuum evaporation apparatus (1) according to claim 1, **characterized in that** the charging device (9) comprises a charging valve (14).

**10.** Vacuum evaporation apparatus (1) according to claim 2, **characterized in that** the crucible (50) comprises a heater.

**11.** Vacuum evaporation apparatus (1) according to claim 2, **characterized in that** the crucible (43) comprises a heater.

**12.** Vacuum evaporation apparatus (1) according to claim 3, **characterized in that** the transporting device (49) comprises a heater.

**13.** Vacuum evaporation apparatus (1) according to claim 1, **characterized in that** the means (51, 52) for cooling the at least one material comprises at least one
pipe (57-60).

**14.** Vacuum evaporation apparatus (1) according to claim 13, **characterized in**
**that** the means (51,52) for cooling the at least one material is a pipe system.

**15.** Vacuum evaporation apparatus (1) according to claims 8 and 9, **characterized**
**in that** the feeder (48) and the valve (14) build a controlling system for keeping the variation of the filling amplitude in the crucibles (43, 50) at a minimum.

**16.** Vacuum evaporation apparatus (1) according to claims 10, 11 and 12,
**characterized in that** the heater is a resistance heater.

**17.** Vacuum evaporation apparatus (1) according to claim 11, **characterized in**
**that** the heater is an inductor.

**18.** Vacuum evaporation apparatus (1) according to claim 11, **characterized in**
**that** the crucible (43) is heated by thermal oil.

**19.** Vacuum evaporation apparatus (1) according to claim 1, **characterized in that** the at least one material is selenium.

**20.** Vacuum evaporation apparatus (1) according to claim 1, **characterized in that** the at least one means (46, 52, 51) for cooling the at least one material also
serves as a means for heating the at least one material.

**21.** Vacuum evaporation apparatus (1) according to claim 1, **characterized in that** the means (46, 52, 51) for cooling are quick shut down devices.
